# EUROPEAN PATENT SPECIFICATION

(11) **EP 1 762 582 B1**
(45) Date of publication and mention of the grant of the patent: **09.05.2012**
(21) Application number: 05730444.6
(22) Date of filing: 14.04.2005
(51) Int. Cl.: C08G 59/62, H01L 23/14, H05K 1/03

(54) **EPOXY RESIN COMPOSITION**
EPOXIDHARZZUSAMMENSETZUNG
COMPOSITION DE RÉSINE ÉPOXY

(30) Priority: 14.04.2004 JP 2004119513
(43) Date of publication of application: 14.03.2007
(73) Proprietor: Namics Corporation, Niigata-shi, Niigata 950-3131 (JP)
(72) Inventor: YAMADA, Toshiaki c/o Namics Corporation, Niigata-shi, Niigata 9503131 (JP); FUJINO, Taku c/o Namics Corporation, Niigata-shi, Niigata 9503131 (JP); TERAKI, Shin c/o Namics Corporation, Niigata-shi, Niigata 9503131 (JP); YOSHIDA, Masaki c/o Namics Corporation, Niigata-shi, Niigata 9503131 (JP); SUZUKI, Kenichi c/o Namics Corporation, Niigata-shi, Niigata 9503131 (JP)
(74) Representative: Setna, Rohan P.
(86) International application number: PCT/JP2005/007202
(87) International publication number: WO 2005/100435

(56) References cited:
- JP-A- 8 034 835
- JP-A- 9 296 026
- JP-A- 10 237 162
- JP-A- 11 060 677
- JP-A- 11 140 166
- JP-A- 2003 252 957
- JP-A- 2003 253 018
- JP-A- 2003 342 350

## Description

### Field of the Invention

The present invention relates to an epoxy resin composition which can form a cured material having low dielectric loss tangent in a radio frequency region, and a film obtained by using the epoxy resin composition. In addition, the present invention is concerned with the epoxy resin composition containing inorganic filler, which can form a cured material having desired electrical and physical properties imparted by the inorganic filler, and a film obtained by using the epoxy resin composition.

### Background Art

In current highly information-oriented society, as typically seen in portable phones, for achieving rapid transmission of information with a large capacity, the frequency used for the information transmission is being increased. For dealing with the increased frequency, in printed wiring boards and module substrates used in electronic devices including information terminal devices, it is necessary to use materials having such a low dielectric loss tangent which can reduce the transmission loss in a radio frequency region.

Conventionally, epoxy resins have widely been used as materials for printed wiring boards. Epoxy resins have excellent dimensional stability under conditions at high temperature and high humidity, excellent heat resistance as well as excellent chemical resistance. They also exhibit excellent electrical properties in a frequency region of 500 MHz or less which has conventionally been employed, and hence the epoxy resins are regarded as materials having the best balance from a practical point of view.

However, in a higher frequency region than the region conventionally employed, for example, in a frequency region as high as 1 to 5 GHz, the epoxy resins are likely to lower in electrical properties, namely, increase in dielectric loss tangent. For example, commercially available epoxy resins for use in substrates have dielectric properties (25°C, 5 GHz) such that the dielectric constant is 3.2 or more and the dielectric loss tangent is as high as 0.02 or more. Therefore, such epoxy resins are not suitable for materials for printed wiring boards, which will be used in a radio frequency region that particularly requires a low dielectric loss tangent.

For improving the epoxy resins in dielectric properties in a radio frequency region, a number of techniques have been proposed (see, for example, patent document 1). However, the techniques have a problem in that a cured material of the epoxy resin in the form of a film is extremely difficult to obtain.
Specifically, there are pointed out the following problems: 1) the resin composition undergoes cohesion during the operation for forming a film, making it difficult to obtain a uniform film; 2) air bubbles are generated during the operation for forming a film, causing pores in a pinhole form in the film; 3) even when a film can be formed, in curing the raw film under predetermined curing conditions, dissolution of the resin is likely to cause the film to suffer cohesion, lowering the properties of the film; and 4) the raw film as a uniform film may be difficult to release from a support PET film with appropriate releasability and apply to an object. Generally, a compound effective in forming a film is likely to worsen the dielectric loss tangent in dielectric properties, and therefore, the development of an epoxy resin composition being suitable for forming a film and having low dielectric loss tangent is expected.

In addition, as electronic devices are being downsized recently, circuit parts used in the electronic devices, such as printed wiring boards and module substrates, are required to have a reduced thickness and an increased density.

In the fabrication of printed wiring boards, an adhesive is generally used for bonding together a conductor (e.g., copper foil) and a dielectric base material (e.g., polyimide film). In other words, a general printed wiring board comprises at least three layers, i.e., a conductive layer, an adhesive layer, and a base material layer. However, a conventional adhesive layer generally has a thickness of 18 to 30 µm, which is near to the thickness of the base material layer, and hence is not preferred from the viewpoint of reducing the thickness of the printed wiring board. Therefore, for meeting the demands of the printed wiring board having a reduced thickness, it is desired that the adhesive layer is reduced in thickness without sacrificing the physical and electrical properties.

On the other hand, in accordance with the increase of component mounting density, problems of heat radiation properties of the resin used in a base film or interlayer dielectric film arise. For example, when a resin film having poor heat radiation properties is used, heat is stored in the resin to lower the reliability of the electronic device. Therefore, for improving the resin film in heat radiation properties, a variety of resin compositions containing thermally conductive inorganic filler have been reported (see, for example, patent document 2). However, such resin compositions have a problem in that the processability is too poor to form a thin film (having a thickness of, e.g., 200 µm or less) exhibiting both desired thermal conductivity and desired insulating properties.
Patent document 1: Japanese Unexamined Patent Publication No. Hei 8-34835
Patent document 2: Japanese Unexamined Patent Publication No. 2003-243835

### DISCLOSURE OF THE INVENTION

### Problem to be Solved by the Invention

An object of the present invention is to solve the above problems and to provide an epoxy resin composition which can form a cured material having low dielectric loss tangent in a radio frequency region (1 to 5 GHz) and a film obtained by using the epoxy resin composition. Another object of the present invention is to provide the epoxy resin composition containing inorganic filler, which can form a cured material having desired electrical and physical properties imparted by the inorganic filler and a film obtained by using the epoxy resin composition. Particularly, an object of the present invention is to provide an epoxy resin composition having excellent processability such that the resin composition can be advantageously used as a material for printed wiring board to reduce the thickness of the board and increase the density of circuit parts, and a film, obtained by using the epoxy resin composition, having both excellent insulating properties and excellent bonding properties.

### Means to Solve the Problem

The present invention provides an epoxy resin according to claim 1 of the claims appended hereto.The present inventors have conducted extensive and intensive studies with a view toward solving the above-mentioned problems. As a result, it has been found that an epoxy resin composition can lower the dielectric loss tangent in a radio frequency region, that a film obtained by using the epoxy resin composition has both excellent insulating properties and excellent bonding properties, and is advantageously used as a material for printed wiring board, and that, even when inorganic filler for imparting other properties (for example, thermal conductivity) is optionally added to the epoxy resin composition, the resultant resin composition can form a thin film, and thus the present invention has been completed.

### Effect of the Invention

In the resin composition of the present invention, it is presumed that, by using at least one bifunctional linear epoxy resin having a weight average molecular weight of 10,000 to 200,000 and having a hydroxyl group represented by formula (2), together with at least one modified phenolic novolac having a phenolic hydroxyl group at least part of which is esterified with a fatty acid represented by formula (3) as a curing agent for the epoxy resin, a bulky group derived from the fatty acid is introduced into the cured polymer to lower the mobility of the polymer, thus making it possible to lower the dielectric constant and dielectric loss tangent. In the present invention, there is provided an epoxy resin composition which can form a cured material having low dielectric constant and low dielectric loss tangent in a radio frequency region (1 to 5 GHz).

The epoxy resin composition of the present invention is suitable for forming a film, particularly forming an adhesive film for use in printed wiring board. In prior art techniques, an epoxy resin film is often in the form of a prepreg using glass fibers, nonwoven fabric and the like, but the epoxy resin composition of the present invention is suitable for forming a film without using glass fibers and the like. When a film is formed from the epoxy resin without using glass fibers and the like, an influence of them on the dielectric properties can be avoided, making it easy to achieve low dielectric constant and low dielectric loss tangent. Further, according to the present invention, an epoxy resin composition which can form a film having dielectric properties (25°C, 5 GHz) such that the dielectric constant is less than 3.2 and the dielectric loss tangent is less than 0.02 can be provided.

The film of the present invention has satisfactory bonding properties to a conductor (preferably, a copper foil) and a dielectric base material, such as polyimide, and hence is advantageously used as an adhesive film for use in printed wiring board. According to the present invention, a thin film can be formed without sacrificing the physical and electrical properties, and thus contributes to the reduction of the thickness of a printed wiring board. For example, in the present invention, an adhesive film with a copper foil can be produced without cumbersome pretreatments, only by applying the resin composition of the present invention to a conductive material (preferably, a copper foil) by a general method and drying the applied composition to form an adhesive film layer on the copper foil, and, if desired, circuits can be continuously formed on the adhesive film with a copper foil. Specifically, an adhesive film with a copper foil can be produced by a continuous and unified process (e.g., a Roll to Roll process), thus reducing the production steps and cost. In addition, the copper foil can be easily handled in such a continuous and unified process, and therefore a copper foil even thinner (e.g., 2 to 12 µm) than a copper foil having a thickness of 18 µm widely used in the prior art techniques can be used, which contributes to the further reduction of the thickness of the printed wiring board.

Further, the resin composition of the present invention is advantageous in that desired properties can be imparted to the composition by adding inorganic filler. For example, when a thermally conductive substance or an unwanted radiation absorbing substance is added as inorganic filler to the resin composition of the present invention, a film obtained by using the resultant resin composition has imparted thermal conductivity or unwanted radiation absorbing properties ascribed to the inorganic filler. On the other hand, when a ceramic dielectric substance is added as inorganic filler to the resin composition of the present invention which exhibits low dielectric constant and low dielectric loss tangent, the dielectric properties, especially dielectric constant can be changed to a higher dielectric constant in a film obtained by using the resin composition, if desired. Furthermore, the resin composition of the present invention has so excellent processability that it is suitable for forming a film as thin as 200µm or less which is difficult to form from a conventional resin composition containing inorganic filler. Therefore, the electrically insulating film obtained by using the resin composition can be used as a film intermediate layer for imparting functions, such as thermal conductivity or unwanted radiation absorbing properties, to the surface for various multilayer wiring boards, such as a glass, glass epoxy, phenol, BT, polyimide and ceramic substrate, or as a film having desired dielectric properties, and thus the film not only meets the current needs of rapid transmission of information with a large capacity but also contributes to the downsizing and weight reduction of electronic devices (prevents heat generation of the parts due to the downsizing, or imparts desired dielectric properties to the circuit).

### BRIEF DESCRIPTION OF THE DRAWINGS

[Fig. 1] Diagrammatic view of an apparatus for measuring electromagnetic wave absorption; 1: network analyzer; 2: signal generator; 3: horn antenna; 4: incident wave; 5: reflected wave; 6: metal reflector; and 7: sample.
[Fig. 2] Attenuation at each frequency measured by the apparatus of Fig. 1.

### BEST MODE FOR CARRYING OUT THE INVENTION

Hereinbelow, the present invention will be described in detail, but the following preferred embodiments should not be construed as limiting the scope of the present invention.

The resin composition of the present invention is according to claim 1 of the claims appended hereto

The bifunctional linear epoxy resin having a weight average molecular weight of 10,000 to 200,000 and having a hydroxyl group preferably has a weight average molecular weight of 15,000 to 70,000. The bifunctional linear epoxy resin preferably has a number average molecular weight of 3,700 to 74,000, more preferably 5,500 to 26,000, and has an epoxy equivalent of 5,000 g/equivalent or more. The weight average molecular weight and number average molecular weight are determined by gel permeation chromatography (GPC) using a calibration curve obtained from standard polystyrene. The bifunctional linear epoxy resin especially preferably has a weight average molecular weight/number average molecular weight ratio in the range of from 2 to 3.

Such epoxy resins are represented by the following formula (2):

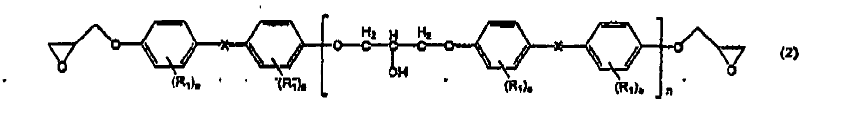

wherein X may be the same or different, each represents a single bond, a hydrocarbon group having 1 to 7 carbon atoms, -O-, -S-, -SO₂-, -CO- or the following group:

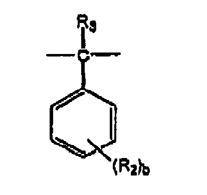

wherein R₂ may be the same or different, each represents a hydrocarbon group having 1 to 10 carbon atoms or a halogen atom;
R₃ represents a hydrogen atom, a hydrocarbon group having 1 to 10 carbon atoms or a halogen atom; and
b may be the same or different, each represents an integer of 0 to 5;
R₁ may be the same or different, each represents a hydrocarbon group having 1 to 10 carbon atoms or a halogen atom;
a may be the same or different, each represents an integer of 0 to 4; and n is 25 to 500 representing an average.

Especially preferred examples include epoxy resins of the formula (2) wherein a is 0, i.e., epoxy resins represented by the following formula (2'):

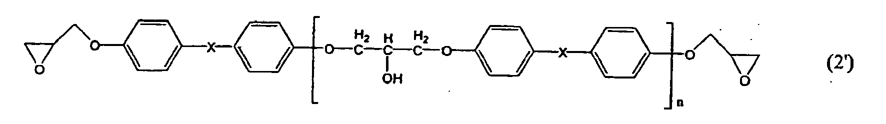

wherein each of X and n is as defined for the formula (2).

These epoxy resins may be used individually or in combination.

The resin composition of the present invention comprises (B) a modified phenolic novolac having a phenolic hydroxyl group, at least part of which is esterified with a fatty acid.

The component (B) is represented by the following formula (3):

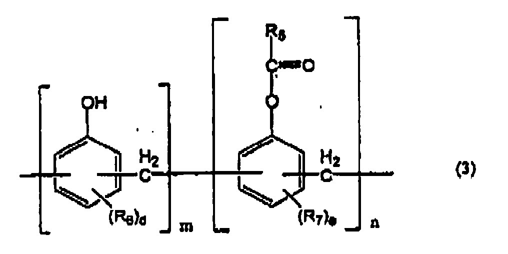

wherein R₅ may be the same or different, each represents an alkyl group having 1 to 5 carbon atoms, preferably a methyl group;
R₆ may be the same or different, each represents an alkyl group having 1 to 5 carbon atoms, a substituted or unsubstituted phenyl group, a substituted or unsubstituted aralkyl group, an alkoxy group or a halogen atom;
R₇ may be the same or different, each represents an alkyl group having 1 to 5 carbon atoms, a substituted or unsubstituted phenyl group, a substituted or unsubstituted aralkyl group, an alkoxy group or a halogen atom;
d may be the same or different, each represents an integer of 0 to 3;
e may be the same or different, each represents an integer of 0 to 3; and
n:m is 1:1 to 1.2:1.
Each of n and m in the formula (3) is an average of the number of repeating units, and the arrangement of the repeating units is not limited, and may be either in a block form or in a random form.

In the formula (3), it is more preferred that the n:m ratio is about 1:1. The total of n and m can be, for example, 2 to 4.

Preferred examples include modified phenolic novolacs of the formula (3) wherein each of d and e is 0, i.e., modified phenolic novolacs represented by the following formula (3'):

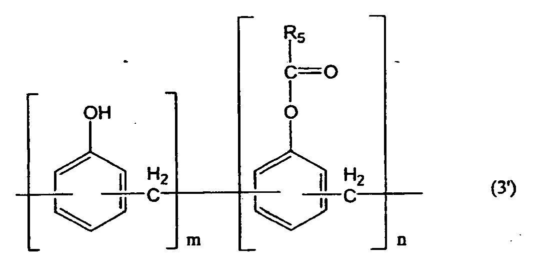

wherein each of R₅, n, and m is as defined above.
Especially preferred examples include acetylated phenolic novolacs of the formula (3') wherein R₅ is a methyl group.

These modified phenolic novolacs may be used individually or in combination.

In the resin composition of the present invention, component (B) can be formulated in an amount of 30 to 200 parts by weight, based on 100 parts by weight of component (A). When the amount of component (B) formulated is in this range, the resultant resin composition is expected to have not only excellent curing properties such that the composition is easily cured into a film but also excellent dielectric properties. It is preferred that component (B) is formulated in an amount of 50 to 180 parts by weight, based on 100 parts by weight of component (A). As component (A) is the bifunctional linear epoxy resin, it is especially preferred that component (B) is formulated in an amount of 120 to 180 parts by weight.

The epoxy resin composition of the present invention optionally contains (C) an isocyanate compound. A hydroxyl group in the epoxy resin or a hydroxyl group formed due to the ring-opening of the epoxy resin is reacted with an isocyanato group in the isocyanate compound to form an urethane linkage, and therefore the cured polymer has an increased crosslinking density and lowered molecular mobility, and has lowered polarity due to the reduction of hydroxyl groups having large polarity. It is believed that it makes possible to further lower the dielectric constant and dielectric loss tangent and hence, when a cured polymer having such dielectric properties is needed, the use of the isocyanate compound in the epoxy resin composition is especially preferred. Further, an epoxy resin generally has a large intermolecular force and hence a uniform film of the epoxy resin is difficult to form, and a film formed from the epoxy resin has such a small film strength that a crack is likely to be caused in the film being formed, but the epoxy resin composition containing isocyanate can solve these problems and is preferred from the viewpoint of achieving excellent processability.

As examples of components (C), there can be mentioned isocyanate compounds having two or more isocyanato groups. Examples include hexamethylene diisocyanate, diphenylmethane diisocyanate, tolylene diisocyanate, isophorone diisocyanate, dicyclohexylmethane diisocyanate, tetramethylxylene diisocyanate, xylylene diisocyanate, naphthalene diisocyanate, trimethylhexamethylene diisocyanate, tolidine diisocyanate, p-phenylene diisocyanate, cyclohexylene diisocyanate, dimer acid diisocyanate, hydrogenated xylylene diisocyanate, lysine diisocyanate, triphenylmethane triisocyanate and tri(isocyanatophenyl) triphosphate. Preferred are HMDI (hexamethylene diisocyanate) and DPMDI (diphenylmethane diisocyanate). The isocyanate compounds include prepolymers formed from an isocyanate compound part of which forms an isocyanurate ring by cyclization. Examples include prepolymers comprising a trimer of isocyanate compounds.

It is especially preferred that component (C) and the bifunctional linear epoxy resin are used in combination. The bifunctional linear epoxy resin has a hydroxyl group and hence, the hydroxyl group can be reacted with an isocyanato group in component (C). Further, a reaction of the isocyanato group with a hydroxyl group formed due to the ring-opening of the epoxy resin proceeds simultaneously, and therefore it is expected that the effect is increased.

Component (C) can be used in an amount of 100 to 400 parts by weight, preferably 300 to 350 parts by weight, based on 100 parts by weight of component (A). When the amount of component (C) formulated is in the above range, not only can foaming be suppressed to form a uniform film, but also a cissing phenomenon is unlikely to occur. Further, a crack is unlikely to be caused in the dried film and thus the film has excellent operability, and the film is expected to have excellent dielectric properties.

The epoxy resin composition of the present invention optionally contains (D) inorganic filler. The inorganic filler further imparts desired electrical and/or physical properties to the epoxy resin composition comprising components (A) to (C), and is appropriately selected according to the use of the resin composition of the present invention, and examples include thermally conductive substances, unwanted radiation absorbing substances and ceramic dielectric substances.

Specifically, examples of thermally conductive substances include oxides such as aluminum oxide and silicon dioxide, and nitrides such as aluminum nitride and boron nitride; examples of unwanted radiation absorbing substances include iron oxides such as ferrite; and examples of ceramic dielectric substances include barium titanate and titanium oxide. It is preferred that the inorganic filler is selected from aluminum nitride, boron nitride, ferrite and ceramic dielectric substances according to the functional film required.

The resin composition of the present invention is per se an epoxy resin composition which can form a cured material having low dielectric constant and low dielectric loss tangent in a radio frequency region, but, from the resin composition containing a ceramic dielectric substance, there can be formed a cured material having a dielectric constant changed from low dielectric constant to high dielectric constant while maintaining the low dielectric loss tangent. A printed wiring board material having high dielectric constant and low dielectric loss tangent is useful for downsizing a printed wiring board generally used in a radio frequency region.

With respect to the amount of the inorganic filler used, there is no particular limitation as long as the amount is such that desired properties can be achieved and a film can be formed from the composition, but it is preferred that the inorganic filler is used in amount of 200 to 500 parts by weight, particularly 350 to 470 parts by weight, more specifically 380 to 420 parts by weight, based on 100 parts by weight of the sum of components (A) to (C) from the viewpoint of achieving excellent dispersibility of the inorganic filler in the resin composition and achieving excellent processability of the resin composition.

The inorganic filler which can be used in the present invention may be in any form such as particles, powder and flakes, but it is preferred that the inorganic filler has an average particle size (or an average maximum diameter when not in a particulate form) of 0.5 µm or less from the viewpoint of achieving excellent dispersibility of the inorganic filler in the resin composition and achieving excellent processability of the resin composition. Especially preferred is inorganic filler having an average particle size of 0.3 µm or less from the viewpoint of forming a thin film.

The inorganic filler which can be used in the present invention may be surface-treated, if necessary.
For example, the inorganic filler may be particles having oxide films formed on their surfaces.

In the resin composition of the present invention, a curing accelerator can be added as an optional component. As a curing accelerator, a known curing accelerator for epoxy resin composition such as a heterocyclic compound imidazole, e.g., 2-ethyl-4-methylimidazole can be used. It is preferred that the curing accelerator is used in an amount of 1 to 10 parts by weight, based on 100 parts by weight of component (A). Further, a polymerization initiator can be formulated, and a known polymerization initiator such as 1,1,3,3-tetramethylbutyl peroxy-2-ethylhexanoate can be used. It is preferred that the polymerization initiator is used in an amount of 1 to 10 parts by weight, based on 100 parts by weight of component (A).

In the resin composition of the present invention, if necessary, an additive, such as a tackifier, a defoamer, a flow control agent, a film forming auxiliary agent and/or a dispersing agent can be formulated. As a film forming auxiliary agent, for example, divinylbenzene can be used. It is preferred that the film forming auxiliary agent is used in an amount of 50 to 150 parts by weight, based on 100 parts by weight of component (A).

In the resin composition of the present invention, for example, for improving the modulus of elasticity, lowering the coefficient of expansion or changing the glass transition temperature (Tg), if necessary, an epoxy resin other than component (A), such as a bisphenol A epoxy resin, a bisphenol F epoxy resin, an alicyclic epoxy resin or a biphenyl epoxy resin can be appropriately selected and formulated as long as the effect aimed at by the present invention is not sacrificed.

In the resin composition of the present invention, a known epoxy resin curing agent such as a phenolic novolac unesterified with a fatty acid, a cresol novolac resin or a substance comprised of several phenol nuclei (e.g., a phenol comprised of 3 to 5 nuclei) can be formulated as long as the effect aimed at by the present invention is not sacrificed.

The resin composition of the present invention can be produced by a method generally used. Components (A) and (B) and optionally component (C) are mixed, for example, in the presence or absence of a solvent, by means of a heating vacuum kneader and then component (D) is optionally added, or the all components may be mixed together at the same time. The resin components are individually dissolved in a solvent at a predetermined concentration, and they are charged in predetermined amounts into a reaction vessel heated to 40 to 60°C and can be mixed with each other under the atmospheric pressure at a rotational speed of 500 to 1,000 rpm for 30 minutes. Then, they can be mixed by stirring in a vacuum (1 torr at maximum) for another 30 to 60 minutes. When stirring component (D) and the other components at the same time, the stirring in a vacuum is preferably continued for another 30 to 60 minutes.

The film of the present invention can be obtained from the resin composition of the present invention by a known method. For example, the resin composition of the present invention is diluted with a solvent to prepare a varnish, and the varnish is applied to at least one side of a support and then dried and/or cured, thus providing an uncured/cured film on the support, or a cured film peeled off the support.

Examples of solvents which can be used in the varnish include ketones such as methyl ethyl ketone and methyl isobutyl ketone; aromatic solvents such as toluene and xylene; and high boiling-point solvents such as dioctyl phthalate and dibutyl phthalate. With respect to the amount of the solvent used, there is no particular limitation, and it can be an amount conventionally employed, preferably 20 to 90% by weight, based on the solids of the composition.

With respect to the support, there is no particular limitation, and it is appropriately selected depending on the desired form in the method for forming a film, and examples include metallic foils of copper, aluminum and the like, and resin carrier films of polyester, polyethylene and the like. When the film formed from the resin composition of the present invention is obtained in the form of a film peeled off the support, it is preferred that the support is subjected to release treatment with a silicone compound or the like.

With respect to the method for applying the varnish, there is no particular limitation, and examples include a slot-die method, a microgravure method and a doctor coater method. The method is appropriately selected according to the desired film thickness and others, but especially preferred is a microgravure method by which a film having a small thickness can be designed. The varnish is applied so that the dried and/or cured film has the thickness of the film of the present invention. Those skilled in the art can lead this thickness from the solvent content.

When the resin composition of the present invention does not contain component (D), the thickness of the film is appropriately designed depending on the properties required for the use, such as mechanical strength, but the thickness of the film is generally 18 to 30 µm, particularly 10 to 30 µm. When an especially thin film is required, the film preferably has a thickness of 10 to 20 µm. Even in this range of the thickness, the film of the present invention can keep satisfactory physical and electrical properties as a material for printed wiring board.

When the resin composition of the present invention contains component (D), the thickness of the film is appropriately designed depending on the properties required for the use, such as mechanical strength, while considering the amount of the inorganic filler contained, but the thickness of the film can be generally 20 to 200 µm, preferably 30 to 90 µm.

With respect to the drying conditions, there is no particular limitation, and the conditions are appropriately designed depending on the type or amount of the solvent used in the varnish, the amount of the varnish used or the thickness of the varnish applied, and, for example, preferred conditions are such that the drying is conducted at 60 to 120°C under the atmospheric pressure.

- With respect to the curing conditions, there is no particular limitation, but, for example, the curing temperature can be stepwise elevated, specifically, the temperature can be stepwise elevated from 80°C to 100°C, 150°C, and then 180°C. The curing time can be selected so that the film maintains a completely cured state.

The present invention is also directed to a film with a conductor, which comprises the film of the present invention and a conductor (preferably a copper foil). The film with a conductor of the present invention may be any film as long as it comprises the film of the present invention and a conductor, and can be obtained by a general method. It is preferred that, for example, as the support mentioned above in connection with the method for forming a film, a metallic foil which is a conductor is used. After being dried and/or cured, the film of the present invention has a satisfactory bonding strength to a metallic foil which is a conductor and a dielectric base material of, e.g., polyimide. Specifically, after being cured, the film having a conductor of the present invention has a practically satisfactory bonding strength such that the peeling strength between the conductor layer and the adhesive film layer is 3 N/cm or more, preferably 5 N/cm or more, more preferably 5 to 10 N/cm.

The conductor used in the film with a conductor of the present invention may be copper, aluminum, silver, platinum or an alloy of the above metal, which can form a conductive layer, but it is preferred that copper is used from the viewpoint of obtaining excellent conductivity and availability. The thickness of the conductive layer depends on the type of the conductor or the method for producing a printed wiring board, but, for example, when a copper foil is used, the copper foil (which may be an electrolytic copper foil or a rolled copper foil) preferably has a thickness of 12 to 35 µm, especially 12 to 18 µm.

Generally, when a copper foil and a dielectric base material are bonded through an adhesive, it is preferred that the copper foil has a thickness of 18 to 35 µm. When a copper foil having a thickness smaller than 18 µm, for example, 12 µm is bonded to a dielectric base material through an adhesive, the copper foil is disadvantageously likely to wrinkle or break, and generally difficult to handle. Therefore, a copper foil having a small thickness which has conventionally been commercially available is difficult to practically use.

On the other hand, in the present invention, as mentioned above, a film having a conductor can be produced by a continuous and unified process comprising applying a varnish of the resin composition of the present invention directly to a support (for example, a copper foil) and drying the varnish applied, and optionally forming circuits on the film. For bonding the resultant adhesive film with a copper foil (optionally having circuits formed thereon) to a dielectric base material, the adhesive film with a copper foil is put on the dielectric base material and the adehisive film layer is cured to fix the copper foil at a desired position, and there is no need to apply an additional adhesive. Therefore, any copper foil having such a small thickness that the foil does not break during the application of the varnish can be used, and the above-mentioned problem of wrinkles or breakage of the copper foil is unlikely to occur, and hence a copper foil even thinner than the copper foil mentioned above, for example, having a thickness of 2 to 12 µm is available, thus achieving further reduction of the thickness of the printed wiring board.

The epoxy resin composition of the present invention and the film obtained by using the epoxy resin composition can be used in a printed wiring board, a module substrate and others. More specifically, the film of the present invention can be used in the production of electronic parts, for example, as an adhesive layer between a conductor layer and a base material in the above-mentioned printed wiring board, e.g., a flexible printed wiring board; as a protective film on the top or bottom of a substrate in the printed wiring board; as an interlayer dielectric film for multilayer wiring board; as a cover film for a protective layer of conductor patterns; or as an insulating film for forming a radio frequency circuit formation layer on the outermost layer of a multilayer printed substrate (made of an organic material or an inorganic material) corresponding to a ground portion.

### Examples

Hereinbelow, the present invention will be described in more detail with reference to the following Examples, which should not be construed as limiting the scope of the present invention. In the following Examples, "part(s)" representing the unit of the amount of the component is given by weight unless otherwise specified.

### Examples 1 and 2 (Example 1 is a reference example not forming part of the present invention) and Comparative Examples 1 to 5

Varnishes of resin compositions having the formulations shown in Table 1 were individually prepared. Then, films were individually formed from the resultant varnishes and examined in accordance with the following Evaluations 1 to 9. The results are shown in Table 1.

### Evaluation 1 (Dielectric properties)

A varnish_ws applied to a film having a release agent (silicone release agent, PET film) as a support using a doctor coater, a slot-die coater or a microgravure coater so that the cured film had a thickness of 2 to 90 µm, and dried to obtain an uncured film.

Then, the film was cured under conditions at 80°C for 30 minutes, at 100°C for 60 minutes, at 150°C for 60 minutes and at 180°C for 60 minutes, and peeled off the support, and then disposed between glass plates heated to 150°C and pressed to obtain a flat film. Another uncured film having the same formulation was stacked on the resultant cured film and cured by heating under vacuum. The film obtained was processed into a sample having a width of 1.5 mm, a length of 80 mm and a thickness of 0.5 mm.

With respect to each sample, a dielectric constant and a dielectric loss tangent were measured at room temperature using a cavity resonator (machine name: perturbation method dielectric meter; manufactured by Kanto Electronics Application Development Inc.). The results are shown in Table 1.

### Evaluation 2 (Coating thickness)

The above-obtained varnish was applied individually to electrolytic copper foils having various thicknesses (2, 5, 12, 18 or 35 µm) using a microgravure coater so that the cured film had a thickness of 2 to 90 µm. Then, the film was cured under conditions at 80°C for 30 minutes, at 100°C for 60 minutes, at 150°C for 60 minutes and at 180°C for 60 minutes. With respect to the resultant film with a copper foil, a coating thickness of the resin layer with which the copper foil was able to remain uncurling was evaluated. The results are shown in Table 1.

### Evaluation 3 (Peeling strength)

The above-obtained varnish was applied individually to electrolytic copper foils having various thicknesses (2, 5, 12, 18 or 35 µm) and dried at 90°C, and then cured at 150°C to obtain a film having a copper foil and having a resin layer thickness of 50 µm. With respect to the obtained film having a copper foil, a peeling strength was measured in accordance with the method described in JIS C5016 8.3. The results are shown in Table 1. The "Copper break" shown in the Table means that the copper itself broken before being peeled off the film.

### Evaluation 4 (Bonding strength under shear)

An evaluation was made in accordance with JIS C6481 5.7 using an uncured film obtained in the same manner as in Evaluation 1. The thickness of the uncured film used was 30 µm. The substrate had a width of 20 mm, and the stacked length was 20 mm. The PMID (polyimide) had a thickness of 250 µm, and other materials used had a thickness of 1 mm. The results are shown in Table 1.

### Evaluation 5 (Storage stability)

An uncured film (thickness: 30 µm) on PET obtained in the same manner as in Evaluation 1 was allowed to stand in an environment at 65 to 85 RH% at 25°C for a predetermined period of time, and then stacked on FR-4 and held by a clip. The film in this state was placed in a dryer at 150°C, and, after 20 minutes, the film was taken out the dryer and checked whether the film was peeled off the PET substrate. The film was peeled off the PET substrate, and disposed between Al and Al and cured at 150°C for 20 minutes, followed by a measurement of lap-shear strength. A sample having a strength within ±5% of the initial value was regarded as a sample having no change. This period of time was used as storage stability. The results are shown in Table 1.

### Evaluation 6 (Transferability)

An uncured film (thickness: 30 µm) on PET obtained in the same manner as in Evaluation 1 was allowed to stand in an environment at 65 to 85 RH% at 25°C, and then stacked on FR-4 and held by a clip. The film in this state was placed in a dryer at 150°C, and after 20 minutes, the film was taken out the dryer and checked whether the film was peeled off the PET substrate. The results are shown in Table 1.

### Evaluation 7 (Dielectric breakdown voltage)

An uncured film having a thickness of 30 µm obtained in the same manner as in Evaluation 1 was put on a 500-µm copper foil and cured at 150°C for 20 minutes. A lead wire was bonded to the copper side by soldering and dipped in silicone oil. An electrode comprising a stainless steel ball having a diameter of 20 mm connected to a lead wire was grounded onto the film, and a voltage applied was increased at a rate of 100 V per second until a current started flowing. A voltage at which a current started flowing was used as a dielectric breakdown voltage, and the voltage was measured five times at different positions to obtain an average of the voltage. The results are shown in Table 1.

### Evaluation 8 (Water absorption rate)

A cured film having a thickness of 125 µm and a size of 100 mm x 100 mm obtained in the same manner as in Evaluation 1 was dried at 100°C for one hour, and an initial weight of the film was determined. Then, the film was allowed to stand in an environment at 85 RH% at 120°C for 24 hours, and from a change of the weight, a water absorption rate of the film was determined. The results are shown in Table 1.

### Evaluation 9 (Solder reflow)

A cured film having a thickness of 25 µm and a size of 20 mm x 20 mm obtained in the same manner as in Evaluation 1 was dipped in a solder bath at 260°C for 10 seconds and this operation was repeated three times, and then the film was visually checked whether or not a blister or crack was formed. The results are shown in Table 1.

**Table 1**

| Formulation | | * Example 1 | Example 2 | Comparative Example 1 | Comparative Example 2 | Comparative Example 3 | Comparative Example 4 | Comparative Example 5 |
|---|---|---|---|---|---|---|---|---|
| | | (Part(s) by weight) | | | | | | |
| (A) | Epoxy resin 1 | 100 | | | | | | |
| | Epoxy resin 2 | | 100 | | | | | |
| | Epoxy resin 3 | | | 100 | | | | |
| | Epoxy resin 4 | | | | 100 | 100 | | |
| | Epoxy resin 5 | | | | 100 | 70 | | |
| | Epoxy resin 6 | | | | | | 60 | |
| | Epoxy resin 7 | | | | | | 100 | |
| | Epoxy resin 8 | | | | | | | 100 |
| (B) | Acetylated phenolic novolak | 50 | 155 | | | | | |
| | Curing agent (Acid anhydride 1) | | | | 80 | 80 | 60 | |
| | Curing agent (Acid anhydride 2) | | | | | | | 80 |
| (O) | Hexemethylene diisocyanate | | 315 | | | | | |
| Curing agent (2-Ethyl-4-methylimidazole) | | 3 | 8 | 3 | 3 | 3 | 3 | 3 |
| Film forming auxiliary agent (Divinylbenzene) | | 67 | 102 | | | | | |
| Initiator (1,1,3,3-Tetramethylbutyl peroxy-2-ethylhexanoate) | | 3 | 8 | | | | | |
| Solvent (Ethyl methyl ketone) | | 97 | 340 | | 90 | 90 | 100 | 100 |
| Evaluation 1: | | Dielectric properties | | | | | | |
| Dielectric constant | 1GHz | 2.52 | -271 | 2.8 | 3 | 3.3. | 3.3 | 3.3 |
| | 2GHz | 2.52 | 2.69 | 3 | 3 | 3.4 | 3.4 | 3.2 |
| | 5GHz | 2.43 | 2.68 | 3.3 | 3 | 3.5 | 3.3 | 3.2 |
| Dielectric loss tangent (tan δ) | 1GHz | 0.0087 | 0.0109 | 0.02 | 0.02 | 0.03 | 0.03 | 0.02 |
| | 2GHz | 0.0091 | 0.0104 | 00.03 | 0.02 | 0.03 | 0.03 | 0.02 |
| | 5GHz | 0.0095 | 0.0098 | 0.02 | 0.09 | 0.04 | 0.03 | 0.02 |
| Evaluation 2: | | Coating thickness (µm) | | | | | | |
| Copper foil thickness (µm) | 35 | 5~90 | 5~80 | Not uniform | Not uniform | Not uniform | Not uniform | Not uniform |
| | 18 | 5~50 | 5~50 | " | " | " | " | " |
| | 12 | 3~20 | 3~20 | Cannot be applied | Cannot be applied | Cannot be applied | Cannot be applied | Cannot be applied |
| | 5 | 3~15 | 3~15 | " | " | " | " | " |
| | 2 | 2~10 | 2~10 | " | " | " | " | " |
| Evaluation 3: | | Peeling strength (N/cm) | | | | | | |
| Copper foil thickness(µm) | 35 | 6~9 | 8~10 | 10< | 10< | 10< | 10< | 10< |
| | 18 | 5~8 | 5~10 | 10< | - | - | - | - |
| | 12 | Copper break | Copper break | - | - | - | - | - |
| | 5 | Copper break | Copper break | - | - | - | - | - |
| | 2 | Copper break | Copper break | - | - | - | - | - |
| Evaluation 4: | | Bonding strength under shear (kg/cm²) | | | | | | |
| Substrate | Polyimide | 20 | 20 | 20 | 30 | 30 | 20 | 20 |
| | AL/AL | 80 | 80 | 80 | 100 | 100 | 80 | 80 |
| | Iron/iron | 80 | 80 | 120 | 130 | 110 | 90 | 90 |
| | Glass epoxy substrate; no copper | 70 | 60 | 120 | 130 | 110 | 80 | 60 |
| Evaluation 5; | | Film strage stability (at 25°C) | | | | | | |
| Period of time | | 9 months | 9 months | 4 hours | 8 hours | 8 hours | 6 hours | 6 hours |
| Evaluation 6; | | Film transferability (at 150°C) | | | | | | |
| Copper foil | | Transferable | Transferable | Cannot | Cannot | Cannot | Cannot | Cannot |
| Polyimide | | Transferable | Transferable | Cannot | Cannot | Cannot | Cannot | Cannot |
| Glass no epoxy substrate; copper | | Transferable | Transferable | Cannot | Cannot | Cannot | Cannot | Cannot |
| Evaluation 7; | | Dielectric breakdown voltage (DC; unit kV) | | | | | | |
| | | 20 | 20 | 60 | 60 | 90 | 90 | 100 |
| Evaluation 8; | | Water absorption rate (24 hr) wt% | | | | | | |
| | | 0.2 | 0.3 | 0.3 | 0.4 | 0.3 | 0.2 | 0.2 |
| Evaluation 9: | | Solder reflow (dipped at 260°C/10 see); Appearance | | | | | | |
| Film thickness (25 µm) | | No change | No change | No change | No change | No change | No change | No change |

| | | | | | | | | |
|---|---|---|---|---|---|---|---|---|
| *Reference example not forming part of the present invention *Solvent: indicated by % by weight, based on solids. *Epoxy resin 1: Novolac epoxy resin having a phenolic skeleton and a biphenyl skeleton, which is represented by formula (1') wherein n is 1 to 1.2. *Epoxy resin 2: Bifunctional linear epoxy resin having a weight average molecular weight of 39,000 and having a hydroxyl group; epoxy equivalent: 12,000 g/equivalent; number average molecular weight: 14,500 *Epoxy resin 3: EP828, manufactured by Dainippon Ink & Chemicals Inc. *Epoxy resin 4: EP1001, manufactured by Dainippon Ink & Chemicals Inc. *Epoxy resin 5: EP1007, manufactured by Dainippon Ink & Chemicals Inc. *Epoxy resin 6: EOCN1020, manufactured by Nippon Kayaku Co., Ltd. *Epoxy resin 7: YX4000H, manufactured by Japan Epoxy Resins Co., Ltd. *Epoxy resin 8: HP4032D, manufactured by Dainippon Ink & Chemicals Inc. *Acetylated phenolic novolac (n:m = 1:1) *Acid anhydride 1: YH306, manufactured by Japan Epoxy Resins Co., Ltd. *Acid anhydride 2: B650, manufactured by Dainippon Ink & Chemicals Inc. *Divinylbenzene: DVB960, manufactured by Nippon Steel Chemical Co., Ltd. | | | | | | | | |

The results shown in Table 1 have confirmed that the film formed from the composition of the present invention has excellent dielectric properties. On the other hand, the film formed from a conventional composition had properties such that the dielectric constant (5 GHz) was 3.0 or more and the dielectric loss tangent (5 GHz) was 0.02 or more. Further, the results shown in Table 1 have confirmed that, even when the film thickness is as small as 2 µm, the film has satisfactory electrical and physical properties.

### Examples 3 to 10 (Examples 3-8 are reference examples not forming past invention) and Comparative Examples 6 and 7

Varnishes of resin compositions containing inorganic filler and having the formulations shown in Table 2 were individually prepared. Then, films were individually formed from the varnishes obtained, and examined in accordance with the Evaluations 1 and 4 to 9 above and the following Evaluations 10 to 13. The results are shown in Table 2.

### Evaluation 10 (Film formability)

A film having a thickness of 20 to 200 µm was formed on PET using a slot-die coater. Uncured films having a dried thickness margin of ±5% were formed. The results are shown in Table 2.

### Evaluation 11 (Film winding properties)

A 10 m uncured film (thickness: 30 µm) was wound round a 37 mm core, and then the film unwound was checked whether a crack or the like was formed. The results are shown in Table 2.

### Evaluation 12 (Thermal conductivity)

Cured films having a thickness of 100 µm were individually obtained in accordance with the method in Evaluation 1 from the varnishes of resin compositions containing thermally conductive filler in Examples 6 and 7, and, with respect to the thermal conductivity of the cured films, a thermal diffusion coefficient was determined by means of LFA 447 Nanoflash, manufactured by NETZSCH Inc., and converted to a thermal conductivity. The results are shown in Table 2.

### Evaluation 13 (Unwanted radiation absorbing properties)

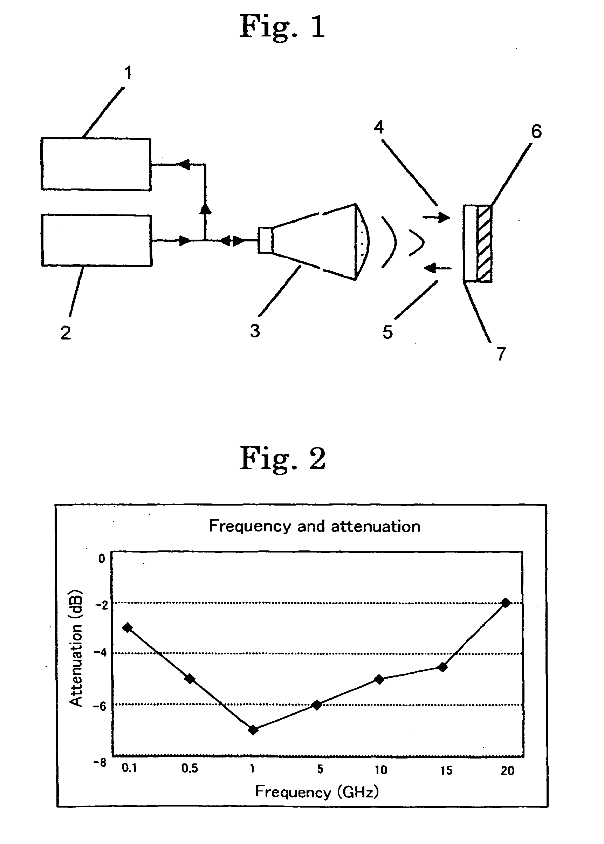

Unwanted radiation absorbing properties were evaluated using a network analyzer (8757D Scalar Network Analyzer/E8247C PSG CW Signal Generator, manufactured by Agilent Technologies) in accordance with the diagrammatic view of Fig. 1. In the measurement of electromagnetic wave absorption, a free space method was employed, and as shown in Fig. 1, a measurement sample (cured film having a thickness of 100 µm obtained in accordance with the method in Evaluation 1 from the varnish of a resin composition containing ferrite as inorganic filler in Example 8) was placed at a position 30 cm from a transmission antenna, and a reflection attenuation S₁₁ was measured to determine electrical radiation absorption properties. The results are shown in Fig. 2.

**Table 2**

| Formulation | | | *Example 3 | *Example 4 | *Example 5 | *Example 6 | *Example 7 |
|---|---|---|---|---|---|---|---|
| | | | (Part(s) by weight) | | | | |
| Solids of resin composition | | Example 1 | 100 | 100 | 100 | 100 | 100 |
| | | Example 2 | | | | | |
| | | Comparative Example 2 | | | | | |
| (D) | Barium titanate | | 380 | 420 | | | |
| | Titanium oxide | | | | 380 | | |
| | Aluminum nitride | | | | | 380 | |
| | Boron nitride | | | | | | 400 |
| | Ferrite | | | | | | |
| Dispersing agent (Silans coupling agent) | | | 0.7 | 0.7 | 0.7 | 0.7 | 0.7 |
| Evaluation 1; | | | Dielectric properties | | | | |
| Dielectric constant | | 5GHz | 10 | 20 | 7 | - | - |
| Dielectric loss tangent (tan δ) | | 5GHz | 0.010 | 0.005 | 0.006 | - | - |
| Evaluation 4; | | | Bonding strength under shear (kg/cm³) | | | | |
| Substrate | Polylmide | | 5 | 3 | 5 | 3 | 5 |
| | Iron/iron | | 15 | 10 | 15 | 10 | 7 |
| | Glass epoxy substrate no copper | | 10 | 10 | 10 | 7 | 5 |
| Evaluation 5; | | | Film storage stability (at 25°C) | | | | |
| Period of time | | | 4 months | 4 months | 4 months | 4 months | 4 months |
| Evaluation 6; | | | Film transferability (at 160°C); transferability after stored at 25°C | | | | |
| Copper foil | | | Transferable | Transferable | Transferable | Transferable | Transferable |
| Polyimide | | | Transfereble | Transferable | Transferable | Transferable | Transferable |
| Glass epoxy substrate; no copper | | | Transferable | Transferable | Transferable | Transferable | Transferable |
| Evaluation 7; | | | Dielectric breakdown voltage (DO; unit kV) | | | | |
| | | | 15 | 10 | 10 | 10 | 10 |
| Evaluation 8; | | | Water absorption rate (24 hr) wt% | | | | |
| | | | 0.2 | 0.3 | 0.3 | 0.3 | 0.5 |
| Evaluation 9; | | | Solder reflow (dipped at 260°C/10 sec); Appearance | | | | |
| Film thickness (100 µm) | | | No change | No change | No change | No change | No change |
| Evaluation 10; | | | Film formability | | | | |
| 20 µm ~ 200µm | | | Yes | Yes | Yes | Yes | Yes |
| Evaluation 11; | | | Film winding properties | | | | |
| Core diameter 37mm | | | Yes | Yes | Yes | Yes | Yes |
| Evaluation 12; | | | Thermal conductivity (W) | | | | |
| Film thickness (100 µm) | | | - | - | - | 7 | 10 |

| Formulation | | | *Example 8 | Example 9 | Example 10 | Comparative Example 6 | Comparative Example 7 |
|---|---|---|---|---|---|---|---|
| | | | (Part(s) by weight) | | | | |
| Solids of resin composition | | Example 1 | 100 | | | | |
| | | Example 2 | | 100 | 100 | | |
| | | Comparative Example 2 | | | | 100 | 100 |
| (D) | Barium titanate | | | 380 | 420 | 380 | 420 |
| | Titanium oxide | | | | | | |
| | Aluminum nitride | | | | | | |
| | Boron nitride | | | | | | |
| | Ferrite | | 420 | | | | |
| Dispersing agent (Silane coupling agent) | | | 0.7 | 0.7 | 0.7 | 0.7 | 0.7 |
| Evaluation 1: | | | Dielectric properties | | | | |
| Dielectric constant | | 5GHz | - | 12 | 20 | 10 | 20 |
| Dielectric loss tangent (tan δ) | | 5GHz | - | 0.010 | 0.005 | 0.5 | 0.3 |
| Evaluation 4: | | | Bonding strength under shear (kg/cm²) | | | | |
| Substrate | Polyimide | | 5 | 7 | | 6 10 | 7 |
| | iron/iron | | 15 | 15 | 12 | - | - |
| | Glace epoxy substrate no copper | | 7 | 15 | 12 | 15 | 10 |
| Evaluation 5: | | | Film storage stability (at 25°C) | | | | |
| Period of time | | | 4 months | 9 months | 9 months | 6 hours | 6 hours |
| Evaluation 6: | | | Film transferability (at 150°C): transferability after stored at 25°C | | | | |
| Copper foil | | | Transferable | Transferable | Transferable | Transferable | Transferable |
| Polyimide | | | Transferable | Transferable | Transferable | Transferable | Trensferable |
| Glass epoxy no copper | | | Transferable | Transferable | Transferable | Transferable | Transferable |
| Evaluation 7; | | | Dielectric breakdown voltage (DC; unit: kV) | | | | |
| | | | 5 | 15 | 10 | 15 | 10 |
| Evaluation 8; | | | Water absorption rate (24 hr) wt% | | | | |
| | | | 0.3 | 0.2 | 0.3 | 0.3 | 0.3 |
| Evaluation 9; | | | Solder reflow (dipped at 260°C/10 sec); Appearance | | | | |
| Film thickness (100 µm) | | | No change | No change | No change | No change | No change |
| Evaluation 10; | | | Film formability | | | | |
| 29 µm∼200 µm | | | Yes | Yes | Yes | No | No |
| Evaluation 11; | | | Film winding properties | | | | |
| Core diameter: 37mm | | | Yes | Yes | Yes | No | No |
| Evaluation 12; | | | Thermal conductivity (W) | | | | |
| Film thickness (100 µm) | | | - | - | - | - | - |

| | | | | | | | |
|---|---|---|---|---|---|---|---|
| Reference example not forming part of the present invention | | | | | | | |

*Barium titanate (dielectric constant: 75; tanδ: 0.05): average particle size: 2 µm
*Titanium oxide: manufactured by Ishihara Sangyo Kaisha Ltd.; average particle size: 1 µm
*Boron nitride: manufactured by Denki Kagaku Kogyo Kabushiki Kaisha (SP-2); average particle size: 0.8 (±0.4) µm
*Unwanted radiation absorbing material (ferrite): manufactured by TODA KOGYO CORP.; average particle size: 0.5 µm
*Aluminum nitride: manufactured by Denki Kagaku Kogyo Kabushiki Kaisha (WF); average particle size: 3 µm

The results shown in Table 2 have confirmed that the film formed from the resin composition containing inorganic filler of the present invention has excellent dielectric properties. On the other hand, the results have confirmed that the film formed from a conventional composition can be thin, and further desired properties can be imparted to the film by addition of inorganic filler without sacrificing other properties including the bonding properties.

### INDUSTRIAL APPLICABILITY

In the present invention, there is provided an epoxy resin composition which can form a cured material having low dielectric loss tangent in a radio frequency region (1 to 5 GHz), and a film obtained by using the resin composition not only meets the current needs of rapid transmission of information with a large capacity but also contributes to the reduction of the thickness of a printed wiring board, etc. and the increase of the density of circuit parts. Further, in the present invention, there is provided the epoxy resin composition containing inorganic filler, which can form a cured material having desired electrical and physical properties imparted by the inorganic filler and having excellent processability, and a film obtained by using the epoxy resin composition has excellent insulating properties and excellent bonding properties as well as desired electrical and physical properties, and hence is advantageously used as, for example, an interlayer dielectric film for multilayer printed wiring board.

## Claims

1. An epoxy resin composition comprising:
(A) at least one bifunctional linear epoxy resin having a weight average molecular weight of 10,000 to 200,000 and having a hydroxyl group represented by the following formula (2) : 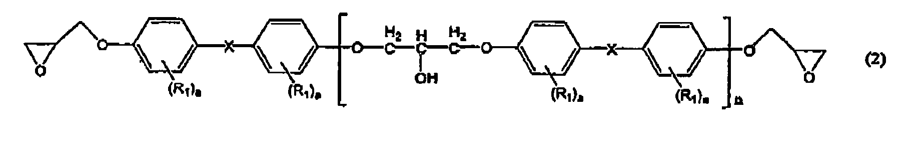 wherein X may be the same or different, each represents a single bond, a hydrocarbon group having 1 to 7 carbon atoms, -O-, -S-, -SO₂-, -CO-, or the following group: 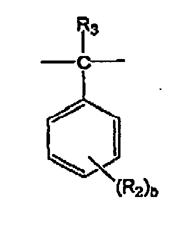 wherein R₂ may be the same or different, each represents a hydrocarbon group having 1 to 10 carbon atoms or a halogen atom;
R₃ represents a hydrogen atom, a hydrocarbon group having 1 to 10 carbon atoms or a halogen atom; and b may be the same or different, each represents an integer of 0 to 5;
R₁ may be the same or different, each represents a hydrocarbon group having 1 to 10 carbon atoms or a halogen atom;
a may be the same or different, each represents an integer of 0 to 4; and
n is 25 to 500 representing an average; and
(B) at least one modified phenolic novolac having a phenolic hydroxyl group, at least part of which is esterified with a fatty acid, represented by the following formula (3) : 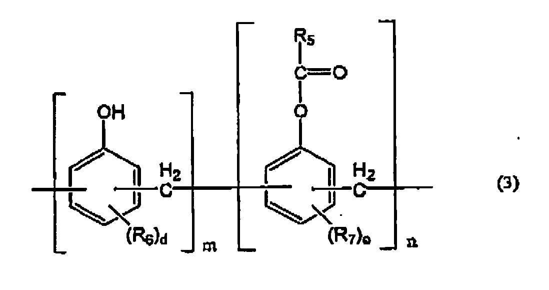 wherein R₅ may be the same or different, each represents an alkyl group having 1 to 5 carbon atoms; R₆ may be the same or different, each represents an alkyl group having 1 to 5 carbon atoms, a substituted or unsubstituted phenyl group, a substituted or unsubstituted aralkyl group, an alkoxy group or a halogen atom;
R₇ may be the same or different, each represents an alkyl group having 1 to 5 carbon atoms, a substituted or unsubstituted phenyl group, a substituted or unsubstituted aralkyl group, an alkoxy group or a halogen atom;
d may be the same or different, each represents an integer of 0 to 3;
e may be the same or different, each represents an integer of 0 to 3; and
n:m is 1:1 to 1.2:1.

2. The epoxy resin composition according to claim 1, wherein the amount of the component (B) is 30 to 200 parts by weight, based on 100 parts by weight of the component (A).

3. The epoxy resin composition according to claim 1, wherein the component (B) is a modified phenolic novolac represented by the formula (3) wherein R₅ is methyl.

4. The epoxy resin composition according to any one of claims 1 to 3, further comprising (C) an isocyanate compound.

5. The epoxy resin composition according to any one of claims 1 to 4, further comprising (D) inorganic filler.

6. The epoxy resin composition according to claim 5, wherein the inorganic filler of component (D) has an average particle size of 5 µm or less.

7. A varnish comprising the epoxy resin composition according to any one of claims 1 to 6.

8. A film obtained by using the epoxy resin composition according to any one of claims 1 to 7.

9. The film according to claim 8, which is used as a protective film, interlayer dielectric film or covering film for multilayer substrate.

10. A film with a copper foil comprising a film layer obtained by using the epoxy resin composition according to any one of claims 1 to 6 and formed directly on a copper foil.

11. The film with a copper foil according to claim 10, whch has a peeling strength between the film layer and the copper foil of 5 N/cm or more.

## Patentansprüche

1. Epoxidharz-Zusammensetzung, die folgendes aufweist:
(A) mindestens ein bifunktionelles lineares Epoxidharz mit einer gewichtsdurchschnittlichen Molmasse von 10.000 bis 200.000 und mit einer Hydroxy-Gruppe, das durch folgende Formel (2) dargestellt wird: 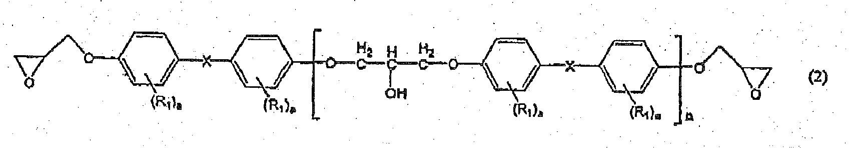 wobei X gleich oder unterschiedlich sein kann, und jeweils eine einfache Bindung, eine Kohlenwasserstoff-Gruppe mit 1 bis 7 Kohlenstoffatomen, -O-, -S-, SO₂-, -CO- oder die folgende Gruppe darstellt: 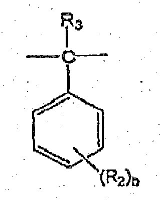 wobei R₂ gleich oder unterschiedlich sein kann, und jeweils eine Kohlenwasserstoff-Gruppe mit 1 bis 10 Kohlenstoffatomen oder ein Halogenatom darstellt; wobei R₃ ein Wasserstoffatom, eine Kohlenwasserstoffgruppe mit 1 bis 10 Kohlenstoffatomen oder ein Halogenatom darstellt; und wobei b gleich oder unterschiedlich sein kann, und jeweils eine Ganzzahl von 0 bis 5 darstellt;
wobei R₁ gleich oder unterschiedlich sein kann, und jeweils eine Kohlenwasserstoff-Gruppe mit 1 bis 10 Kohlenstoffatomen oder ein Halogenatom darstellt; wobei a gleich oder unterschiedlich sein kann, und jeweils eine Ganzzahl von 0 bis 4 darstellt; und
wobei n 25 bis 500 ist und einen Mittelwert darstellt; und
(B) mindestens ein modifiziertes Phenol-Novolac mit einer Phenol-Hydroxyl-Gruppe, wovon zumindest ein Teil mit einer Fettsäure verestert ist, welches Phenol-Novolac durch folgende Formel (3) dargestellt wird: 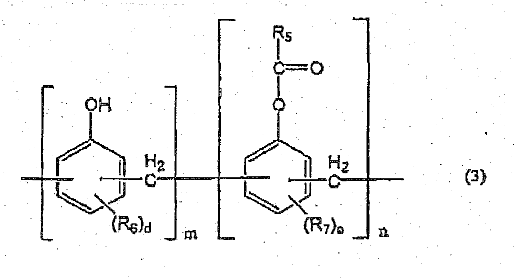 wobei R₅ gleich oder unterschiedlich sein kann, und jeweils eine Alkylgruppe mit 1 bis 5 Kohlenstoffatomen darstellt;
wobei R₆ gleich oder unterschiedlich sein kann, und jeweils eine Alkylgruppe mit 1 bis 5 Kohlenstoffatomen, eine substituierte oder nicht-substituierte Phenylgruppe, eine substituierte oder nicht-substituierte Aralkylgruppe, eine Alkoxygruppe oder ein Halogenatom darstellt;
wobei R₇ gleich oder unterschiedlich sein kann, und jeweils eine Alkylgruppe mit 1 bis 5 Kohlenstoffatomen, eine substituierte oder nicht-substituierte Phenylgruppe, eine substituierte oder nicht-substituierte Aralkylgruppe, eine Alkoxygruppe oder ein Halogenatom darstellt;
wobei d gleich oder unterschiedlich sein kann, und jeweils eine Ganzzahl von 0 bis 3 darstellt;
wobei e gleich oder unterschiedlich sein kann, und jeweils eine Ganzzahl von 0 bis 3 darstellt; und
wobei n:m 1:1 bis 1,2:1 beträgt.

2. Epoxidharz-Zusammensetzung nach Anspruch 1; wobei die Menge der Komponente (B) 30 bis 200 Gewichtsanteile beträgt, basierend auf 100 Gewichtsanteilen der Komponente (A).

3. Epoxidharz-Zusammensetzung nach Anspruch 1, wobei die Komponente (B) ein modifiziertes Phenol-Novolac ist, dargestellt durch die Formel (3), wobei R₅ Methyl ist.

4. Epoxidharz-Zusammensetzung nach einem der Ansprüche 1 bis 3, die des Weiteren (C) eine Isocyanat-Verbindung aufweist.

5. Epoxidharz-Zusammensetzung nach einem der Ansprüche 1 bis 4, die des Weiteren (D) einen anorganischen Füllstoff aufweist.

6. Epoxidharz-Zusammensetzung nach Anspruch 5, wobei der anorganische Füllstoff der Komponente (D) eine durchschnittliche Partikelgröße von 5 µm oder weniger aufweist.

7. Lack, der die Epoxidharz-Zusammensetzung nach einem der Ansprüche 1 bis 6 aufweist.

8. Schicht, die unter Verwendung der Epoxidharz-Zusammensetzung nach einem der Ansprüche 1 bis 7 erzeugt wird.

9. Schicht nach Anspruch 8, die als Schutzschicht, dielektrische Zwischenschicht oder als Deckschicht für ein mehrschichtiges Substrat verwendet wird.

10. Schicht mit einer Kupferfolie, die eine Filmschicht aufweist, die unter Verwendung der Epoxidharz-Zusammensetzung nach einem der Ansprüche 1 bis 6 erzeugt und direkt auf einer Kupferfolie ausgebildet wird.

11. Schicht mit einer Kupferfolie nach Anspruch 10, die eine Schälfestigkeit zwischen der Filmschicht und der Kupferfolie von 5 N/cm oder mehr aufweist.

## Revendications

1. Composition de résine époxy comprenant:
(A) au moins une résine époxy bifonctionnelle linéaire ayant une masse moléculaire moyenne en poids de 10000 à 200 000 et ayant un groupe hydroxyle représenté par la formule suivante (2): 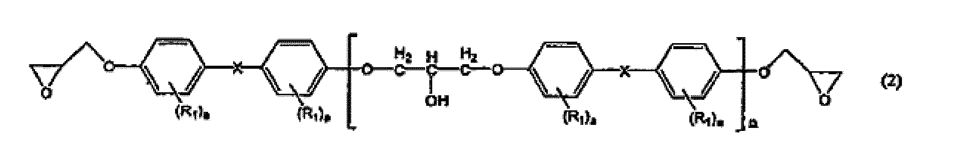 où X peut être identique ou différent, chacun représente une liaison simple, un groupe hydrocarbure ayant 1 à 7 atomes de carbone, -O-, -S-, SO₂-, -CO-, ou le groupe suivant: 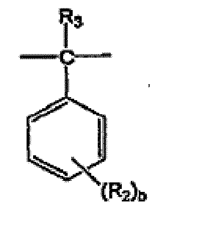 où R₂ peut être identique ou différent, chacun représente un groupe hydrocarbure ayant 1 à 10 atomes de carbone ou un atome d'halogène;
R₃ représente un atome d'hydrogène, un groupe hydrocarbure ayant 1 à 10 atomes de carbone ou un atome d'halogène; et
b peut être identique ou différent, chacun représente un entier de 0 à 5;
R₁ peut être identique ou différent, chacun représente un groupe hydrocarbure ayant 1 à 10 atomes de carbone ou un atome d'halogène;
a peut être identique ou différent, chacun représente un entier de 0 à 4; et
n est 25 à 500 représentant une moyenne; et
(B) au moins une novolaque phénolique modifiée ayant un groupe hydroxyle phénolique, dont au moins une partie est estérifiée avec un acide gras, représenté par la formule suivante (3): 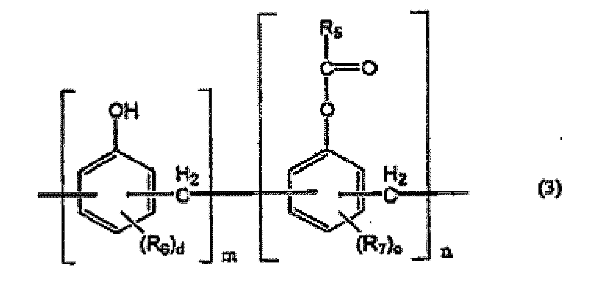 où R₅ peut être identique ou différent, chacun représente un groupe alkyle ayant 1 à 5 atomes de carbone;
R₆ peut être identique ou différent, chacun représente un groupe alkyle ayant 1 à 5 atomes de carbone, un groupe phényle substitué ou non substitué, un groupe aralkyle substitué ou non substitué, un groupe alkoxy ou un atome d'halogène;
R₇ peut être identique ou différent, chacun représente un groupe alkyle ayant 1 à 5 atomes de carbone, un groupe phényle substitué ou non substitué, un groupe aralkyle substitué ou non substitué, un groupe alkoxy ou un atome d'halogène;
d peut être identique ou différent, chacun représente un entier de 0 à 3; et
e peut être identique ou différent, chacun représente un entier de 0 à 3; et
n:m est 1:1 à 1,2:1.

2. Composition de résine époxy selon la revendication 1, où la quantité du composant (B) représente 30 à 200 parties en poids, basée sur 100 parties en poids du composant (A).

3. Composition de résine époxy selon la revendication 1, où le composant (B) est une novolaque phénolique modifiée représentée par la formule (3), où R₅ est méthyle.

4. Composition de résine époxy selon l'une quelconque des revendications 1 à 3, comprenant en outre (C) un composé d'isocyanate.

5. Composition de résine époxy selon l'une quelconque des revendications 1 à 4, comprenant en outre (D) une charge inorganique.

6. Composition de résine époxy selon la revendication 5, où la charge inorganique du composant (D) a une taille de particule moyenne de 5µm ou moins.

7. Vernis comprenant la composition de résine époxy selon l'une quelconque des revendications 1 à 6.

8. Film obtenu en utilisant la composition de résine époxy selon l'une quelconque des revendications 1 à 7.

9. Film selon la revendication 8, qui est utilisé comme un film de protection, un film diélectrique d'intercouche ou un film de recouvrement d'un substrat à couches multiples.

10. Film avec une feuille de cuivre comprenant une couche de film obtenue en utilisant la composition de résine époxy selon l'une quelconque des revendications 1 à 6 et formé directement sur une feuille de cuivre.

11. Film avec une feuille de cuivre selon la revendication 10, qui a une résistance au détachement entre la couche de film et la feuille de cuivre de 5 N/cm ou plus.
